# EUROPÄISCHE PATENTSCHRIFT

(11) **EP 2 264 472 B1**
(45) Veröffentlichungstag und Bekanntmachung des Hinweises auf die Patenterteilung: **30.05.2018**
(21) Anmeldenummer: 10005262.0
(22) Anmeldetag: 11.10.2006
(51) Int. Cl.: G01R 31/14, G01R 31/08, G01R 27/26

(54) **Einrichtung zur Messung des Verlustfaktors**
DEVICE FOR MEASURING THE LOSS FACTOR
DISPOSITIF DE MESURE DU FACTEUR DE PERTES

(30) Priorität: 19.10.2005 AT 17132005
(43) Veröffentlichungstag der Anmeldung: 22.12.2010
(62) Teilanmeldung aus: 06804346.2
(73) Patentinhaber: b2 electronic GmbH, 6833 Klaus (AT)
(72) Erfinder: Baldauf, Stefan, 6830 Rankweil (AT); Blank, Rudolf, 6832 Sulz (AT)
(74) Vertreter: Torggler & Hofinger Patentanwälte

(56) Entgegenhaltungen:
- WO-A2-2004/028003
- JP-A- 63 266 366
- US-A- 3 189 818
- US-A- 3 826 981
- US-A- 4 112 354
- US-A- 4 316 254
- US-A- 4 794 327
- "MODEL PAXLHV-PAX LITE AC VOLTAGE MONITOR", Oktober 2003 (2003-10), RED LION CONTROLS, XP002424671, Gefunden im Internet: URL:http://www.redlion.net/Products/Groups /ACVolt/PAXLHV/Docs/04028.pdf> [gefunden am 2007-03-14] * Seite 5, Absatz 3.0 *

## Beschreibung

Die vorliegende Erfindung betrifft eine Einrichtung zur Messung des Verlustfaktors und/oder zur Messung des Phasenwinkels zwischen Spannung und Strom und/oder zur Aufzeichnung eines Ausschwingvorganges der Spannung und/oder des Stroms und/oder zur Aufzeichnung von Teilentladungsvorgängen und/oder zur Laufzeitmessung an zu prüfenden Messobjekten, wobei die Einrichtung ein Gehäuse, in dem zumindest eine Messschaltung zur Durchführung der Messung und/oder Aufzeichnung angeordnet ist, umfasst. Die Dokumente US3189818 und US4112354 offenbaren Messeinrichtungen zur Bestimmung eines Phasenwinkels beziehungsweise zur Detektion von Teilentladungen mittels abgleichbarer Brückenschaltungen.

Bisher bekannte gattungsgemäße Systeme werden mit einer eigenen Zuleitung an einen Spannungsgenerator angeschlossen und wiederum mit einer eigenen Leitung mit dem zu prüfenden Messobjekt verbunden. Darüber hinaus sind zusätzlich noch eigene Erdungsleitungen zwischen Generator, der Messeinrichtung und dem Messobjekt notwendig. Vor allem bei höheren Betriebsspannungen treten durch die verwendeten meist sehr langen Kabel Störungen der Messungen und damit Verfälschungen der Messwerte durch parasitäre Effekte, Ableitströme, Einstreuungen usw. auf.
Es soll ermöglicht werden, die genannten Störungen der Messung bzw. Verfälschungen der Messwerte durch konstruktive Maßnahmen soweit wie möglich zu minimieren.
Dies kann erreicht werden, indem am Gehäuse ein Anschlussadapter für den direkten Anschluss des zu prüfenden Messobjektes an das Gehäuse vorgesehen ist.
Unter direktem Anschluss ist dabei zu verstehen, dass der Anschlussadapter so kurz wie möglich gehalten werden soll. Bevorzugt ist also ein unmittelbares Anschließen des Messobjektes an das Gehäuse und somit ein Abstand von 0 mm. Aus rein geometrischen Gründen ist es, um den Anschluss an das Messobjekt zu ermöglichen, aber häufig nötig, dass der Messadapter eine Länge von höchstens 10 mm bis 50 mm aufweist. Bei schwer zugänglichen Messobjekten kann es aber auch der Fall sein, dass Anschlussadapterlängen bis zu 1 m von Nöten sind. All dies ist als direkter Anschluss an das Gehäuse zu verstehen. Dies ermöglicht es, die Messung ohne die beim Stand der Technik bekannten langen zusätzlichen Verbindungsleitungen zum Messobjekt durchzuführen, was zur Vermeidung von Störeffekten und damit zu präziseren Messwerten führt. Darüber hinaus ist durch den Anschlussadapter auch der Anschlussaufwand verringert.

Um die Einstreuung von Störsignalen noch weiter zu unterbinden, ist vorgesehen, dass die Einrichtung ein zum Anschluss an einen Spannungsgenerator vorgesehenes koaxiales Kabel mit zumindest einem Innenleiter und zumindest einem Außenleiter aufweist.

Eine Aufgabe der Erfindung besteht darin, eine sehr kompakte und gut handhabbare Messeinrichtung bereitzustellen. Es sollen auch die Störeinflüsse soweit wie möglich reduziert sein.

Dies wird für eine Einrichtung mit den Merkmalen des Oberbegriffs von Anspruch 1 dadurch erreicht, dass die Messschaltung einen ohmschen Spannungsteiler aufweist, welcher an den Außenleiter des Koaxialkabels angeschlossen ist und dass die Messschaltung eine Stromerfassungseinrichtung aufweist, welche an den Innenleiter des Koaxialkabels angeschlossen ist.

Besonders günstig ist es dabei, wenn das koaxiale Kabel als solches in das Gehäuse geführt ist und erst innerhalb des Gehäuses der Innenleiter und der Außenleiter getrennt voneinander an die Komponenten der Messschaltung angeschlossen sind.

Gemäß dieses Aspektes der Erfindung ist zwischen dem Spannungsgenerator und dem Gehäuse nur noch ein einziges koaxiales Kabel vorgesehen, das vorzugsweise erst im Inneren des Gehäuses für den Anschluss an die Messschaltung aufgespalten wird. Hierdurch ergibt sich eine optimale Abschirmung.

Das Gehäuse kann dabei günstiger Weise in der Form eines, vorzugsweise zylinderförmigen, Kabelkopfes ausgeführt sein, in welchen am hinteren Ende das Koaxialkabel eingeführt ist und am vorderen Ende direkt das Messobjekt angeschlossen werden kann.

Die erfindungsgemäßen Einrichtungen können bevorzugt im sogenannten Hochspannungsbereich eingesetzt werden. Als zu prüfende Messobjekte kommen zum Beispiel Kondensatoren, Induktivitäten, Widerstände und insbesondere Hochspannungskabel, Transformatoren, Motoren, Generatoren, Schalter und Relais in Frage. Von Hochspannung spricht man bei Effektivwerten der Messspannungen von mindestens 500 V(Volt), vorzugsweise von mindestens 1 kV (kiloVolt). Für die genannten Messobjekte sind Messspannungen mit Effektivwerten von 12 kV bis 36 kV besonders geeignet, sodass die erfindungsgemäßen Einrichtungen bevorzugt für diesen Spannungsbereich ausgelegt sind. Bevorzugt sind dabei Frequenzen der Wechselspannungen zwischen 0,001Hz (Hertz) und 1kHz (kiloHertz) vorgesehen. Durch Anpassung der Gehäuseabmessungen sind auch noch höhere Spannungen realisierbar.

Weitere Einzelheiten und Merkmale der vorliegenden Erfindung werden anhand der in den Figuren dargestellten Ausführungsbeispiele der Erfindung erläutert. Dabei zeigen:
- Fig. 1 und 2: eine Anordnung aus Hochspannungsgenerator und erfindungsgemäßem Ausführungsbeispiel der Messeinrichtung, welche wiederum an zwei verschiedene Messobjekte angeschlossen ist,
- Fig. 3: einen schematisierten Schnitt durch ein erfindungsgemäße Ausführungsbeispiel einer Messeinrichtung gemäß Fig. 1 und 2 für die Bestimmung des Verlustfaktors und/oder des Phasenwinkels zwischen Strom und Spannung,
- Fig. 4: einen schematisierten Schnitt durch ein erfindungsgemäßes Ausführungsbeispiel einer Messeinrichtung gemäß Fig. 1 und 2 für die Aufzeichnungen eines Ausschwingvorganges der Spannung und/oder des Stroms,
- Fig. 5: einen schematisierten Schnitt durch ein erfindungsgemäßes Ausführungsbeispiel einer Messeinrichtung gemäß Fig. 1 und 2 für die Aufzeichnung von Teilentiadungsvorgängen, und
- Fig. 6: einen schematisierten Schnitt durch ein erfindungsgemäßes Ausführungsbeispiel einer Messeinrichtung gemäß Fig. 1 und 2 zur Laufzeitmessung.

Das Gehäuse 9 ist, wie in den Figuren dargestellt, bei diesen Ausführungsbeispielen in Form eines Kabelkopfes ausgebildet. Am hinteren Ende mündet das Koaxialkabel 3 in den Kabelkopf bzw. das Gehäuse 9. Am vorderen, dem Messobjekt 7 zugewandten Ende hat das ansonsten zylinderförmige. Gehäuse 9 eine elektrisch leitfähige, vorzugsweise metalene, kugelschalenförmige Abschlusskappe 30, In der - elektrisch leitend mit der Abschlusskappe 30 verbunden - ein Anschluss 8 für den Anschlussadapter 12 oder der Anschlussadapter 12 selbst vorgesehen ist. Generell ist günstiger Weise vorgesehen, dass der Anschlussadapter 12 am zu prüfenden Messobjekt 7 und/oder an der Abschlusskappe 30 in abnehmbarer Form elektrisch und/oder mechanisch anschließbar ist. Dies kann über eine Steckverbindung und/oder über eine entsprechende Schraubverbindung und/oder über eine Klemmverbindung oder dergleichen realisiert sein. Die Form des Anschlussadapters 12 ist je nach zu prüfendem Messobjekt unterschiedlich auszubliden. So können Ausführungsformen des Anschlussadapters In Form von Haken und/oder Klemmen und/oder kurzen, vorzugsweise hoch flexiblen, Verbindungsleitungen vorgesehen sein. Generell Ist dabei im Sinne der Erfindung aber darauf zu achten, dass der Anschlussadapter möglichst kurz gehalten ist, um einen möglichst direkten Anschluss des zu prüfenden Messobjektes 7 an das Gehäuse 9 bzw. dessen Abschlusskappe 30 zu ermöglichen.

Bis auf die Abschlusskappe 30 kann das Gehäuse aus elektrisch isolierendem Material, zum Beispiel in Form eines Kunststoffgehäuses 9a, ausgeführt sein. in der Regel ist das Gehäuse somit zweiteilig ausgeführt.

Das hinten aus dem Kabelkopf bzw. Gehäuse 9 herausführende Koaxialkabel wird über einen Steckverbinder 2 oder dergleichen an einen handelsüblichen Spannungsgenerator bzw. Hochspannungsgenerator 1 angeschlossen. Diese Generatoren weisen meist einen eigenen Schuterdeanschluss 4 auf. Zur Messung des Verlustfaktors und/oder des Phasenwinkels zwischen Spannung und Strom kommen bevorzugt Wechsel(hoch)spannungsgeneratoren mit sinusförmigem Ausgangssignal zum Einsatz.

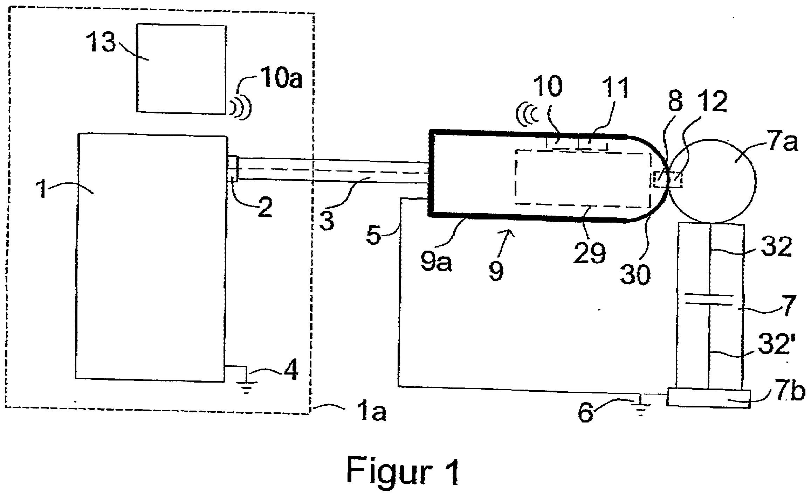

In Fig. 1 ist schematisch eine Messsituation dargestellt, bei der als Messobjekt 7 ein Kondensator überprüft werden soll. Der Anschlussadapter 12 ist dabei direkt an einen kugelförmigen Hochspannungsanschluss 7a der Zuleitung 32 des Kondensators angeschlossen. Die andere Zuleitung 32' des Kondensators ist elektrisch an einen Schutzerdeanschluss 7b für das Messobjekt 7 angeschlossen. Der Schutzerdeanschluss 7b des Messobjektes wie auch das optional vorhandene Schutzerdungskabel 5 der Messeinrichtung sind elektrisch leitend mit einem externen Schutzerdungsanschluss 6 verbunden.

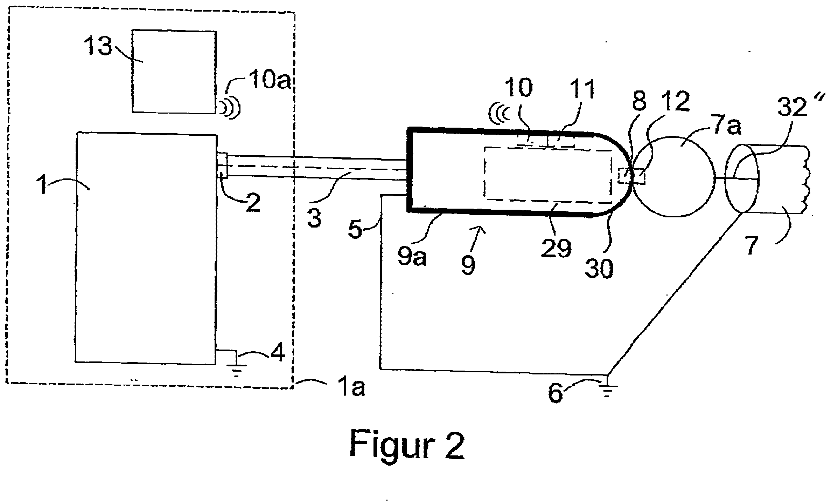

In Fig. 2 ist schematisiert eine Messsituation dargestellt, bei der es um die Überprüfung eines Hochspannungskabels als Messobjekt 7 geht. Hier ist der Anschlussadapter 12 direkt an einen kugelförmigen Hochspannungsanschluss 7a des Leitungskabels 32" des Messobjektes 7 angeschlossen. Bei beiden Ausführungsbeispielen (gemäß Fig. 1 und 2) ist das Vorhandensein der kugelförmigen Hochspannungsanschlüsse 7a optional.

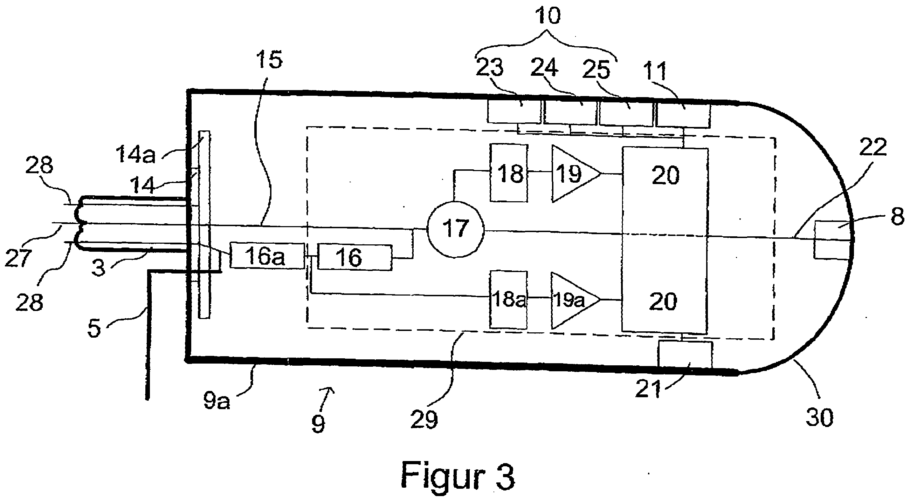

Fig. 3 zeigt am Beispiel einer Einrichtung zur Messung des Verlustfaktors und/oder des Phasenwinkels zwischen Spannung und Strom einen schematisierten Längsschnitt durch das Gehäuse 9 und das darin mündende Koaxialkabel 3. Letzteres führt in geschlossener Form, also als Koaxialkabel, In das Innere des Gehäuses 9 hinein und wird erst dort an die entsprechenden Komponenten der im inneren des Gehäuses 9 angeordneten Messschaltung angeschlossen. Im gezeigten Ausführungsbeispiel ist die Abschirmung, also der Außenleiter 28, des Koaxialkabels 3 über eine Feldsteuerplatte 14a an einen ohmschen Spannungsteiler angeschlossen. Dieser weist ein Niederspannungselement 16 und ein Hochspannungselement 16a auf. Der Abgriff vom Spannungsteiler erfolgt über einen Überspannungsschutz 18a im Spannungssignalpfad, welcher über einen Filter und Verstärker 19a an die Auswerteinheit 20 angeschlossen ist. Die Stromerfassungseinrichtung 17 (passiv oder aktiv möglich) ist Ober den Hochspannungs-Endverschluss 14 und eine Zuleitung 15 an den innenleiter 27 des Koaxialkabels 3 angeschlossen. Über den Stromsignalpfad ist die Stromerfassungseinrichtung 17 mit einem Überspannungsschutz 18 und einem dazu in Reihe geschalteten Filter und Verstärker 19 mit der Auswerteeinrichtung 20 verbunden. Des Weiteren führt eine Zuleitung 22 von der Stromerfassungseinrichtung 17 um die Auswerteeinheit 20 herum zum Anschluss 8 für den Anschlussadapter 12. In der gezeigten Weise Ist die Integration der Messschaltung in den Kabelkopf und ein Einbau des Spannungsteilers und der Stromerfassungseinrichtung 17 direkt in den Kabellauf möglich. Die Auswerteeinheit 20 sowie weitere Komponenten der Messschaltung sind durch ein Metallgehäuse 29 gegen äußere elektrische Felder abgeschirmt Die Auswerteeinheit 20 umfasst günstiger Weise mindestens einen A/D-Wandier und/oder eine digitale Filtereinrichtung bzw. Signalüberarbeitungseinrichtung und/oder eine Berechnungseinrichtung zur Berechnung des Verlustfaktors und/oder des Phasenwinkels zwischen Spannung und Strom. In der Regel wird somit eine digitale Auswertung der Messwerte angestrebt, wozu ein Mikroprozessor verwendet werden kann. Der Aufbau der Messschaltung sowie die Art der Auswertung der gemessenen Strom- und Spannungssignale ist an sich bekannt, sodass auf weitere Ausführungen hierzu verzichtet werden kann.

Für eine schnelle Messung oder eine erste Überblicksmessung sieht das gezeigte Ausführungsbeispiel eine optische Messwertanzeige 11 am Gehäuse 9 vor. Diese kann in Form von Leuchtdioden ausgeführt sein. Alternativ wäre es auch möglich eine akustische Messwertausgabe vorzusehen. Darüber hinaus kann zusätzlich oder anstelle dessen am Gehäuse 9 zumindest eine. Datenübertragungseinrichtung 10 zur Übertragung von Daten auf externe Datenbearbeitungs- und/oder Datenanzeigeeinrichtungen 13 wie zum Beispiel PC's (Personal Computer), Laptops, Pocket PC's, Mobiltelefone, PDA's, Handhelds. Drucker und dergleichen angeordnet sein. Die Übertragung auf diese externen Geräte kann sowohl kabelgebunden als auch kabellos erfolgen. Möglich sind unter anderem Funkschnittstellen 23, bevorzugt im Hochfrequenzbereich, wie zum Beispiel Blue-Tooth-Schnittstellen, und/oder optische kabellose Schnittstellen 24, wie zum Beispiel Infrarotschnittstellen und/oder optische kabelgebundene Schnittstellen 26, wie zum Beispiel Lichtwellenleiterschnittstellen. Die externe Datenbearbeitungs- und/oder Datenanzelgeelnrichtung 13 kann, wie in den Fig. 1 und 2 dargestellt, auch In den Generator 1 integriert sein. Sie weist für die Datenübertragung jedenfalls eine oder mehrere entsprechende Schnittstellen 10a auf. Die Messschaltung wird bevorzugt per Batterie 21 versorgt, wodurch eine von der Schutzerde losgelöste Stromerfassung ermöglicht wird,

Das optional vorhandene Schutzerdungskabel 5 ist innerhalb des Gehäuses an den Außenleiter 28 angeschlossen und führt als solches aus dem Gehäuse 9 heraus, um an einen externen Schutzerdungsanschluss 6 angeschlossen werden zu können. Auch hier ist auf eine möglichst geringe Leitungslänge zu achten. Durch das Schutzerdungskabel 5 kann eine weitere Unterdrückung von Störeinflüssen erreicht werden. Das Kabel 5 muss aber nicht vorhanden sein. Das Bezugspotential der Messanordnungen bzw. Messschaltungen gemäß Fig. 3 bis 6 ist die Hochspannung. Diesbezüglich umfasst die Messanordnung insbesondere die jeweils innerhalb des Gehäuses 29 eingezeichneten Bauteile und/oder das Gehäuse 29 selbst Unter Hochspannung sind dabei insbesondere Effektivwerte der Spannungen von mindestens 500 V, vorzugsweise mindestens 1 kV, gegen die Schutzerde zu verstehen. Insbesondere können aber auch Effektivwerte der Spannungen gegen die Schutzerde von 12 kV bis 36 kV In diesem Sinne vom Begriff der Hochspannung umfasst sein. Günstigerweise liegt die Messanordnung bzw. Messschaltung somit auf Hochspannung gegenüber der Schutzerde. Prinzipiell lässt sich die Messanordnung gemäß Fig. 3 aber auch so abändern, dass die Schutzerde das Bezugspotential darstellt. Aus messtechnischen sowie konstruktiven Gründen wird aber das Hochspannungspotential bevorzugt.

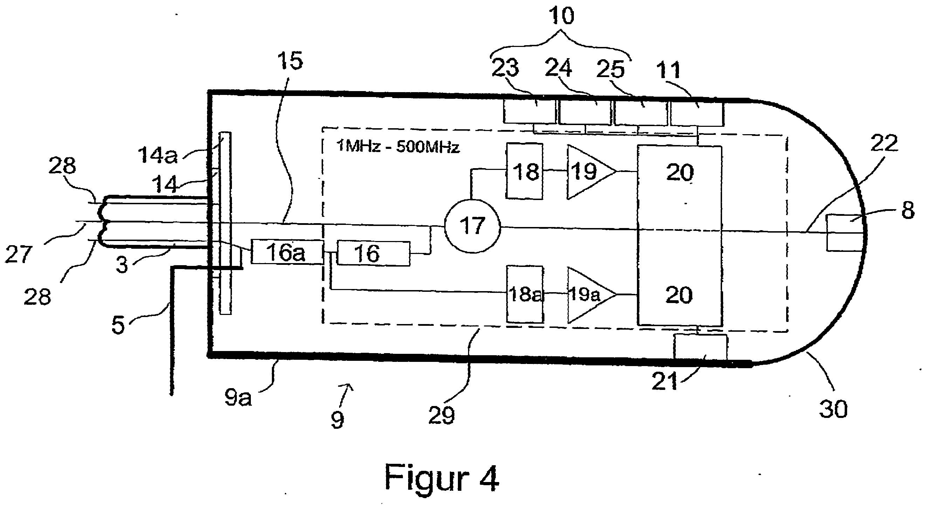

Die Figuren 4 bis 6 zeigen Varianten, bei denen die erfindungsgemäße Einrichtung so ausgebildet ist, dass sie als so genannter Transientenrekorder für die Kabelfehlervorortung eingesetzt werden kann. Tritt ein Kabelfehler auf, so muss dieser zuerst lokalisiert werden. Dies gilt vor allem bei sehr langen Kabeln mit mehreren Kilometern Länge. Um den Kabelfehler einzugrenzen, gibt es verschiedene beim Stand der Technik bekannte Feldmassverfahren, welche aber letztendlich alle auf der Auswertung von transienten Vorgängen beruhen. Je nach Messverfahren und Randbedingungen kann der Fehler im Kabel bis auf ca. ein bis fünf Meter genau lokalisiert werden. Anschließend wird in der Regel auf die Nachortung der Fehlerquelle übergegangen, wozu andere beim Stand der Technik bekannte, hier aber nicht weiter ausgeführte Messverfahren eingesetzt werden.

Fig. 4 zeigt eine erfindungsgemäße Variante einer Einrichtung für die Aufzeichnung eines Ausschwingvorganges der Spannung oder eines Stromstoßes. Entsprechend werden als Generatoren 1 auch Spannungsgeneratoren für sinusförmige Wechselspannungen oder Stromstoßgeneratoren eingesetzt Zur Aufzeichnung und Auswertung dieser Ausschwingvorgänge ist grundsätzlich eine analoge Ausbildung der in Fig. 3 gezeigten Messschaltung möglich. Allerdings muss die Schaltung, wie in Fig. 4 gezeigt, so angepasst werden, dass auch schneliere Vorgänge aufgezeichnet werden können. In der Regel ist es hierbei nötig die Schaltung so auszulegen, dass Abtastfrequenzen von mindestens 1 MHz, vorzugsweise zwischen 1 MHz (Mega Hertz) und 500 MHz, oder auch über 500 MHz möglich sind. Ist dies gegeben, so kann diese Einrichtung (gemäß Fig. 4) auch als Transientenrekorder für die Aufzeichnung und Auswertung von Ausschwingvorgängen bei der Kabelfehlerortung eingesetzt werden.

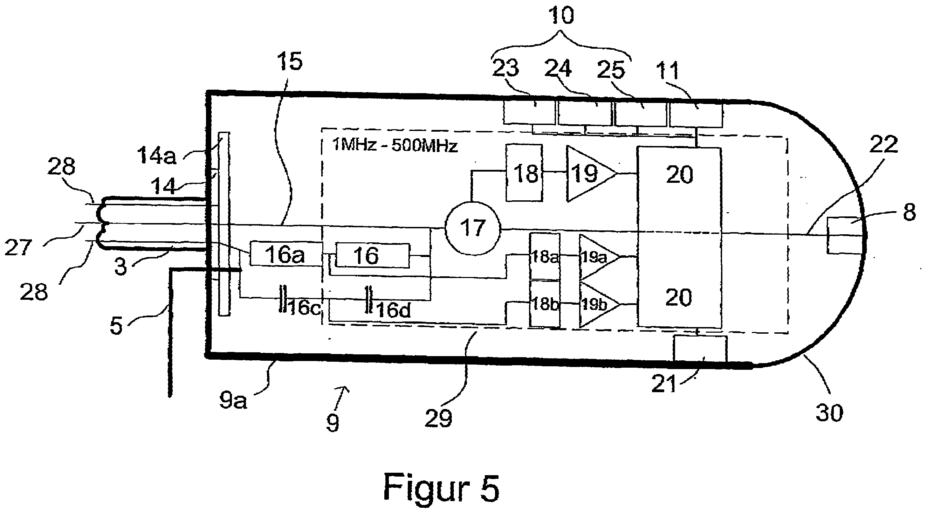

Fig. 5 zeigt ein erfindungsgemäßes Ausführungsbeispiel, das zur Teilentladungsdiagnostik, also zur Aufzeichnung von Tellentladungsvorgängen in Messobjekten wie z.B. Kabeln geeignet ist. Hierzu wird der aus Fig. 3 bereits bekannte ohmsche Spannungsteiler 16, 16a durch einen kapazitiven Spannungsteiler 16c (Hochspannungselement), 16d (Niederspannungselement) ersetzt oder, wie in Fig. 5 gezeigt, durch Parallelschalten ergänzt. Das so modifizierte System kann dann wiederum als Transientenrekorder zur Aufzeichnung von Teilentladungsvorgängen eingesetzt werden, wobei es zu beachten gilt, dass die Ankopplung an das Kabel selbst teilentladungsarm sein sollte. Auch hier sind entsprechend schnelle elektronische Bauteile mit Abtastfrequenzen von mindestens 1 MHz, vorzugsweise zwischen 1 MHz und 500 MHz, oder auch über 500 MHz einzusetzen. Aufgezeichnet wird bei diesem grundsätzlich bekannten Messverfahren die Laufzeit sowie der Tellentladungspegel des Signals, welches bei einer Teilentladung im Kabel zum Beispiel an einer Fehierstelle entsteht.

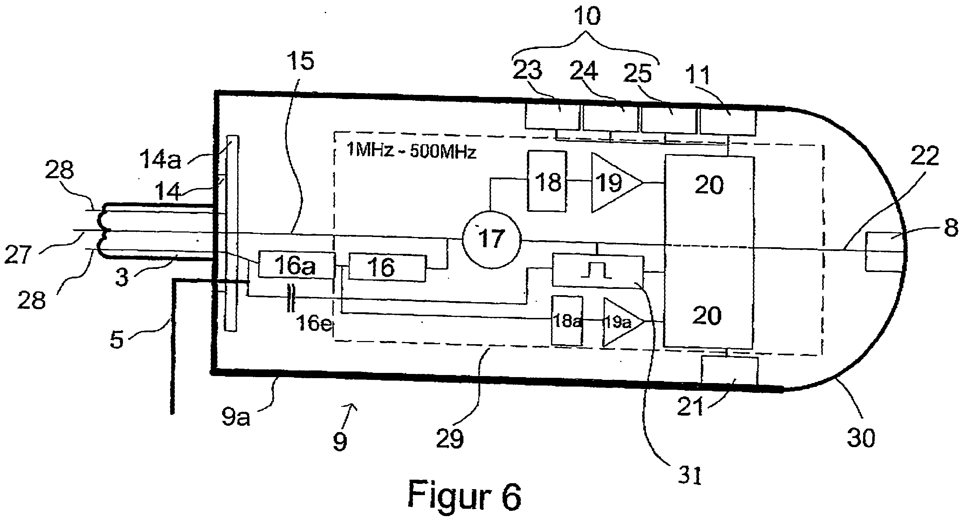

Fig. 6 zeigt ein weiteres modifiziertes erfindungsgemäßes Ausführungsbeispiel. Dies ist ebenfalls zur Laufzeitmessung Im zu prüfenden Messobjekt (zum Beispiel im zu prüfenden Kabel) geeignet. Allerdings ist bei dem System gemäß Fig. 6 ein eigener Pulsgenerator 31 über einen Koppelkondensator 16e in die Messschaltung integriert, Es können somit Laufzeiten von durch den Pulsgenerator erzeugten Signalen Im Messobjekt bestimmt werden. Die so ausgebildete Einheit Ist als Laufzeitmessgerät mit integrierter Hochspannungsankopplung verwendbar. Auf Grundlage der gemessenen Laufzeiten Ist dann eine Kabelfehlervorortung möglich. Auch hier sollte die Messschaltung dazu geeignet sein, mit Abtastfrequenzen von mindestens 1 MHz, vorzugsweise zwischen 1 MHz und 500 MHz, oder auch Ober 500 MHz zu arbeiten. Angeschlossen wird die so ausgebildete erfindungsgemäße Einrichtung wie auch das Ausführungsbeispiel gemäß Fig. 5 an Spannungsgeneratoren 1 bzw. Hochspannungsgeneratoren mit sinusförmigem oder stoßförmigem Ausgangssignal.

Durch die erfindungsgemäßen Maßnahmen werden sehr gut handhabbare und direkt an die Messobjekte 7 anschließbare Geräte geschaffen, deren Gewicht günstigerweise zwischen 3 kg und 5 kg bzw. darunter liegt. Durch die Verwendung eines Koaxialkabels 3 zwischen Gehäuse 9 und Spannungsgenerator 1 ist eine optimale Abschirmung der Zuleitung zur Messschaltung gegeben, wodurch die maximale Länge der Leitung 3 auch im Hochspannungsbereich nahezu unbegrenzt Ist Typische Kabellängen liegen zwischen 5 m und 100 m. Durch das Einführen des Koaxialkabels 3 bis in das Innere des Gehäuses 9 sind Störeinflüsse zusätzlich weitgehend unterbunden. In Abwandlung des gezeigten Ausführungsbeispiels ist es aber auch möglich einen entsprechenden Anschlussstecker mit einem eigenen Gehäuse am Koaxialkabel 3 vorzusehen, wobei der Stecker dann direkt in das Gehäuse der Messeinrichtung eingesteckt wird. Auch dies ist als Einführen des koaxialen Kabels 3 in das Gehäuse 9 zu verstehen.

## Patentansprüche

1. Einrichtung zur Messung des Verlustfaktors und/oder zur Messung des Phasenwinkels zwischen Spannung und Strom und/oder zur Aufzeichnung eines Ausschwingvorganges der Spannung und/oder des Stroms und/oder zur Aufzeichnung von Teilentladungsvorgängen und/oder zur Laufzeitmessung an zu prüfenden Messobjekten (7), wobei die Einrichtung ein Gehäuse (9), in dem zumindest eine Messschaltung zur Durchführung der Messung und/oder Aufzeichnung angeordnet ist, umfasst, wobei die Einrichtung ein zum Anschluss des Gehäuses (9) an einen Spannungsgenerator (1) vorgesehenes koaxiales Kabel (3) mit zumindest einem Innenleiter (27) und zumindest einem Außenleiter (28) aufweist, wobei die Messschaltung eine Stromerfassungseinrichtung (17) aufweist, **dadurch gekennzeichnet, dass** die Messschaltung einen ohmschen Spannungsteiler aufweist, welcher an den Außenleiter (28) des Koaxialkabels (3) angeschlossen ist und dass die Stromerfassungseinrichtung (17) an den Innenleiter (27) des Koaxialkabels (3) angeschlossen ist.

2. Einrichtung nach Anspruch 1, **dadurch gekennzeichnet, dass** am Gehäuse (9) ein Anschlussadapter (12) für den direkten Anschluss des zu prüfenden Messobjektes (7) an das Gehäuse (9) vorgesehen ist.

3. Einrichtung nach Anspruch 2, **dadurch gekennzeichnet, dass** der Anschlussadapter (12) am zu prüfenden Messobjekt (7) und/oder am Gehäuse (9), vorzugsweise über eine Steckverbindung (8) und/oder über eine Schraubverbindung und/oder über eine Klemmverbindung abnehmbar elektrisch und/oder mechanisch anschließbar ist.

4. Einrichtung nach Anspruch 2 oder 3, **dadurch gekennzeichnet, dass** der Anschlussadapter (12) mindestens einen Haken und/oder mindestens eine Klemme und/oder mindestens eine kurze, vorzugsweise hoch flexible, Verbindungsleitung aufweist.

5. Einrichtung nach einem der Ansprüche 2 bis 4, **dadurch gekennzeichnet, dass** der Anschlussadapter (12) höchstens 1 m, vorzugsweise höchstens 10 mm bis 50 mm, lang ist.

6. Einrichtung nach einem der Ansprüche 1 bis 5, **dadurch gekennzeichnet, dass** das koaxiale Kabel (3) als solches in das Gehäuse (9) geführt ist und erst innerhalb des Gehäuses (9) der Innenleiter (27) und der Außenleiter (28) getrennt voneinander an die Komponenten der Messschaltung angeschlossen sind.

7. Einrichtung nach einem der Ansprüche 1 bis 6, **dadurch gekennzeichnet, dass** der Spannungsteiler ein Niederspannungselement (16, 16d) und ein Hochspannungselement (16a, 16c) aufweist.

8. Einrichtung nach einem der Ansprüche 1 bis 7, **dadurch gekennzeichnet, dass** die Messschaltung eine zentrale Auswerteeinheit (20), vorzugsweise mit einem Mikroprozessor, aufweist.

9. Einrichtung nach Anspruch 8, **dadurch gekennzeichnet, dass** die zentrale Auswerteeinheit (20) mindestens einen A/D-Wandler und/oder eine digitale Filtereinrichtung bzw. Signalbearbeitungseinrichtung und/oder eine Berechnungseinrichtung zur Berechnung des Verlustfaktors und/oder des Phasenwinkels zwischen Spannung und Strom aufweist.

10. Einrichtung nach einem der Ansprüche 1 bis 9, **dadurch gekennzeichnet, dass** die Messschaltung eine Taktfrequenz von mindestens 1 MHz, vorzugsweise zwischen 1 MHz und 500 MHz, aufweist und vorzugsweise zur Aufzeichnung von transienten Vorgängen bei der Kabelfehlerortung geeignet ist.

11. Einrichtung nach einem der Ansprüche 1 bis 10, **dadurch gekennzeichnet, dass** die Messschaltung einen Pulsgenerator (31) aufweist.

12. Einrichtung nach einem der Ansprüche 1 bis 11, **dadurch gekennzeichnet, dass** am Gehäuse (9) eine optische Messwertanzeige (11), vorzugsweise in Form von Leuchtdioden, und/oder eine akustische Messwertausgabe angeordnet ist.

13. Einrichtung nach einem der Ansprüche 1 bis 12, **dadurch gekennzeichnet, dass** im oder am Gehäuse (3) zumindest eine Datenübertragungseinrichtung (10) zur Übertragung von Daten auf externe Datenbearbeitungs- und/oder Datenanzeigeeinrichtungen (13) angeordnet ist.

## Claims

1. A device for measuring the loss factor and/or for measuring the phase angle between a voltage and a current and/or for recording a decay process of the voltage and/or the current and/or for recording partial discharge processes and/or for transit time measurement on test objects (7), wherein the device comprises a housing (9) in which there is arranged at least one test circuit for carrying out the measurement and/or recording operation, wherein the device comprises a coaxial cable (3) which is provided for connection of the housing (9) to a voltage generator (1) and which has at least one internal conductor (27) and at least one external conductor (28), wherein the test circuit comprises a current detection device (17), **characterized in that** the test circuit has an ohmic voltage divider which is connected to the external conductor (28) of the coaxial cable (3), and **in that** the current detection device (17) is connected to the internal conductor (27) of the coaxial cable (3).

2. The device according to claim 1, **characterized in that** a connecting adaptor (12) for direct connection of the test object (7) to the housing (9) is provided on the housing (9).

3. The device as set forth in claim 2, **characterized in that** the connecting adaptor (12) can be electrically and/or mechanically connected removably to the test object (7) and/or to the housing (9), preferably by way of a plug connection (8) and/or by way of a screw connection and/or by way of a clamping connection.

4. The device as set forth in claim 2 or claim 3, **characterized in that** the connecting adaptor (12) has at least one hook and/or at least one clamp and/or at least one short, preferably highly flexible connecting line.

5. The device as set forth in one of claims 2 through 4, **characterized in that** the connecting adaptor (12) is at most 1 m, preferably at most between 10 mm and 50 mm, long.

6. The device as set forth in one of claims 1 through 5, **characterized in that** the coaxial cable (3) as such is guided into the housing (9) and it is only within the housing (9) that the internal conductor (27) and the external conductor (28) are connected separately from each other to the components of the test circuit.

7. The device as set forth in one of claims 1 through 6, **characterized in that** the voltage divider comprises a low voltage element (16, 16d) and a high voltage element (16a, 16c).

8. The device as set forth in one of claims 1 through 7, **characterized in that** the measuring circuit comprises a central evaluation unit (20), preferably with a microprocessor.

9. The device as set forth in claim 8, **characterized in that** the central evaluation unit (20) has at least one A/D converter and/or a digital filter device respectively a signal processing device and/or a calculating device for calculating the loss factor and/or the phase angle between voltage and current.

10. The device as set forth in one of claims 1 through 9, **characterized in that** the test circuit has a clock frequency of at least 1 MHz, preferably between 1 MHz and 500 MHz, and is preferably suitable for recording transient processes in cable fault location.

11. The device as set forth in one of claims 1 through 10, **characterized in that** the test circuit comprises a pulse generator (31).

12. The device as set forth in one of claims 1 through 11, **characterized in that** an optical measurement value display (11), preferably in the form of light emitting diodes, and/or an acoustic measurement value output means, is arranged at the housing (9).

13. The device as set forth in one of claims 1 through 12, **characterized in that** at least one data transfer device (10) for the transfer of data to external data processing and/or data display devices (13) is arranged in or on the housing (3).

## Revendications

1. Equipement pour la mesure du facteur de perte et/ou pour la mesure de l'angle de phase entre tension et courant et/ou pour l'enregistrement d'un processus d'amortissement de la tension et/ou du courant et/ou pour l'enregistrement de processus de décharge partielle et/ou pour la mesure du temps de propagation sur des objets (7) de mesure à contrôler, l'équipement comprenant un boîtier (9), dans lequel est disposé au moins un circuit de mesure pour la réalisation de la mesure et/ou l'enregistrement, en ce que l'équipement présente un câble coaxial (3) présente au moins un conducteur intérieur (27) et au moins un conducteur extérieur (28), le câble coaxial (3) est prévu pour la connexion du boîtier (9) à un générateur de tension (1), en ce que le circuit de mesure présente un équipement de détection de courant (17) **caractérisé en ce que** le circuit de mesure présente un diviseur de tension ohmique qui est connecté au conducteur extérieur (28) du câble coaxial (3) et **en ce que** l'équipement de détection de courant (17) est connecté au conducteur intérieur (27) du câble coaxial (3).

2. Equipement selon la revendication 1, **caractérisé en ce qu'**un adaptateur de connexion (12) étant prévu sur le boîtier (9) pour la connexion directe de l'objet de mesure (7) à contrôler.

3. Equipement selon la revendication 2, **caractérisé en ce que** l'adaptateur de connexion (12) peut être connecté de façon électriquement et/ou mécaniquement amovible sur l'objet de mesure (7) à contrôler et/ou sur le boîtier (9), de préférence par le biais d'une connexion par fiche (8) et/ou par le biais d'une connexion vissée et/ou par le biais d'une connexion par serrage.

4. Equipement selon la revendication 2 ou la revendication 3, **caractérisé en ce que** l'adaptateur de connexion (12) présente au moins un crochet et/ou au moins une borne et/ou au moins une ligne de connexion courte, de préférence très flexible.

5. Equipement selon une des revendications 2 à 4, **caractérisé en ce que** l'adaptateur de connexion (12) a une longueur maximale de 1 m, de préférence maximale de 10 mm jusqu'au 50 mm.

6. Equipement selon une des revendications 1 à 5, **caractérisé en ce que** le câble coaxial (3) est conduit en tant que tel dans le boîtier (9) et le conducteur intérieur (27) et le conducteur extérieur (28) n'étant connectés à des composants du circuit de mesure qu'à partir de l'intérieur du boîtier (9) séparément l'un de l'autre.

7. Equipement selon une des revendications 1 à 6, **caractérisé en ce que** le diviseur de tension présente un élément basse tension (16, 16d) et un élément haute tension (16a, 16c).

8. Equipement selon une des revendications 1 à 7, **caractérisé en ce que** le circuit de mesure présente une unité d'analyse (20) centrale, de préférence avec un microprocesseur.

9. Equipement selon la revendication 8, **caractérisé en ce que** l'unité d'analyse (20) centrale présente au moins un convertisseur A/N et/ou un équipement de filtrage numérique ou un équipement de traitement du signal et/ou un équipement de calcul pour calculer le facteur de perte et/ou l'angle de phase entre tension et courant.

10. Equipement selon une des revendications 1 à 9, **caractérisé en ce que** le circuit de mesure présente une fréquence d'horloge d'au moins 1 MHz, de préférence entre 1 MHz et 500 MHz, et est de préférence approprié pour l'enregistrement de processus transitoires lors de la localisation des défauts de câble.

11. Equipement selon une des revendications 1 à 10, **caractérisé en ce que** le circuit de mesure présente un générateur d'impulsions (31).

12. Equipement selon une des revendications 1 à 11, **caractérisé en ce que**, sur le boîtier (9), est disposé un afficheur optique de valeurs de mesure (11) de préférence sous la forme de diodes électroluminescentes, et/ou une sortie acoustique de valeurs de mesures.

13. Equipement selon une des revendications 1 à 12, **caractérisé en ce que**, dans ou sur le boîtier (9), il est disposé au moins un équipement de transmission de données (10) pour la transmission de données à des équipements externes de traitement de données et/ou d'affichage de données (13).
